(19) Europäisches Patentamt
European Patent Office
Office européen des brevets

(11) **EP 3 381 063 B1**

(12) **EUROPEAN PATENT SPECIFICATION**

(45) Date of publication and mention
of the grant of the patent:
**09.10.2019 Bulletin 2019/41**

(51) Int Cl.:
***H01L 35/32*** *(2006.01)*

(21) Application number: **16804869.2**

(86) International application number:
**PCT/GB2016/053699**

(22) Date of filing: **24.11.2016**

(87) International publication number:
**WO 2017/089813 (01.06.2017 Gazette 2017/22)**

(54) **THERMOELECTRIC MODULE**

THERMOELEKTRISCHES MODUL

MODULE THERMOÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **27.11.2015 GB 201520950**

(43) Date of publication of application:
**03.10.2018 Bulletin 2018/40**

(73) Proprietor: **European Thermodynamics Limited
Kibworth, Leicester LE8 0RX (GB)**

(72) Inventors:
• **TULEY, Richard
Leicester
Leicestershire LE8 0RX (GB)**
• **SIMPSON, Kevin
Leicester
Leicestershire LE8 0RX (GB)**

(74) Representative: **Barker Brettell LLP
100 Hagley Road
Edgbaston
Birmingham B16 8QQ (GB)**

(56) References cited:
**WO-A1-2013/006640     JP-A- 2005 268 284
SU-A1- 1 073 824**

• **ZHANG JIANZHONG ET AL: "A method of diode parallel to improve the reliability of the thermoelectric coolers", THERMOELECTRICS, 1997. PROCEEDINGS ICT '97. XVI INTERNATIONAL CONFEREN CE ON DRESDEN, GERMANY 26-29 AUG. 1997, NEW YORK, NY, USA,IEEE, US, 26 August 1997 (1997-08-26), pages 690-692, XP010275154, DOI: 10.1109/ICT.1997.667624 ISBN: 978-0-7803-4057-2**

**Description**

The present invention relates to thermoelectric modules. In particular, the present invention provides thermoelectric modules having improved fault tolerance and output characteristics.

Thermoelectric modules may be used in devices for cooling, heating or power generation. Thermoelectric modules are all solid-state, with no moving parts, and so they are usually lighter, smaller and acoustically quieter than equivalent mechanical systems. Thermoelectric modules are often used in applications which require a high reliability and long lifetime. For example, thermoelectric generators comprising one or more thermoelectric modules can be used to provide a low maintenance power supply to a device in a remote or inaccessible location. As such, thermoelectric devices are also environmentally friendly and relatively inexpensive, e.g. by eliminating the need to frequently replace batteries.

Generally, standard thermoelectric modules have little tolerance to failure of a single component within the module. For example, since the thermoelectric elements in standard thermoelectric modules are connected in series, an open circuit failure of any one element or any of the electrical interconnects which connect a pair of elements, causes complete failure of the whole module. A more fault resistant module would lead to an improved reliability and lifetime.

In order to improve the fault tolerance of a thermoelectric module, it is known to provide one or more bypass circuits within the module to bypass one or more failed or faulty thermoelectric elements. For example, WO9522188 discloses a fault tolerant thermoelectric device circuit for a thermoelectric cooler. A primary or secondary electrical bypass circuit is activated using a sensor and a switch within the bypass circuit in response to a failure of one or more thermoelectric elements.

US3632451 discloses a thermoelectric device having parallel circuits interconnected at equal potential points, each parallel circuit comprising a number of thermoelectric couples (thermocouples) connected electrically in series. This provides tolerance to failure of any one component of the circuit.

SU 1073824 discloses a thermoelectric battery with nichrome wire resistances connected in parallel across each N-type and P-type element forming the thermocouples. The resistances act as a shunt electrical path in case of failure of one of the thermoelectric elements.

However, known thermoelectric modules with improved fault tolerance typically provide significantly reduced output or performance characteristics, even before a fault has occurred, compared with standard thermoelectric modules. For example, known thermoelectric generators with improved fault tolerance often produce significantly lower output voltages, which can make it difficult to interface the device efficiently with the required electrical system, or lower output powers which are insufficient for their purpose.

In a first aspect of the present invention, there is provided a thermoelectric module comprising:

a plurality of thermocouples electrically connected in series to provide a main electrical path through the thermoelectric module, each thermocouple comprising an n-type thermoelectric element and a p-type thermoelectric element; and
at least one shunt electrical path connected in parallel to a portion of the main electrical path, the portion of the main electrical path comprising at least one of the thermocouples;
wherein the resistance of a given shunt electrical path is less than the resistance of the main electrical path and more than the resistance of the portion of the main electrical path with which the given shunt electrical path is in parallel.

Thus, the at least one shunt electrical path of the present invention provides an alternative electrical path for current to follow in the event of a failure of a component (e.g. a thermoelectric element) within the portion of the main electrical path with which the shunt electrical path is in parallel. This improves the fault tolerance of the thermoelectric module.

Advantageously, by specifically selecting the resistance of the shunt electrical path based on the resistance of the main electrical path and the resistance of the portion of the main electrical path with which the given shunt electrical path is in parallel, the thermoelectric module of the present invention ensures that there is only a small decrease in the outputs of the module (e.g. output power) before a fault occurs, and only a small further drop in performance after one or more faults occur.

For example, if the resistance of the shunt electrical path were lower than the resistance of the portion of the main electrical path with which the given shunt electrical path is in parallel, then current would predominantly flow through the shunt electrical path rather than the main electrical path, affecting the performance of the module.

Additionally, if the resistance of the shunt electrical path were too high, then, in the event of a fault, the performance of the module could be significantly affected, as the current through the shunt electrical path would be very low. The inventors of the present invention have discovered that if the resistance of the shunt electrical path is less than the resistance of the main electrical path (i.e. less than the total resistance through the thermoelectric module), then the performance of the module is not significantly limited in the event of a failure. Thus, the present invention provides a fault tolerant thermoelectric module with improved performance characteristics.

In the event of a failure of a component within the portion of the main electrical path with which the at least one shunt electrical path is in parallel, the resistance of the portion of the main electrical path tends to infinity and so the current will automatically be diverted through the shunt electrical path which now has a lower resistance than the portion of the main electrical path.

The present invention may therefore be more cost effective and simple to manufacture compared to known fault tolerant thermoelectric modules, as it does not require any switches or intricate electrical circuits within the shunt electrical path. Moreover, since the shunt electrical path is a passive element requiring no threshold voltages, it can provide fault tolerance for a range of module designs under any operating conditions with a high reliability.

The at least one shunt electrical path may comprise an elongate electrically conductive element such as a wire. Optionally, the at least one shunt electrical path may comprise at least one resistor. In some embodiments, the shunt electrical path may comprise additional circuit components.

Optionally, the resistance of a given shunt electrical path, $R_s$, may satisfy the equation:

$$\frac{1}{2}\left(R_{portion}+\left(R_{portion}+R_{main}\right)^{0.5}\right)< R_s < 5\left(R_{portion}+\left(R_{portion}+R_{main}\right)^{0.5}\right)$$

wherein $R_{main}$ is the resistance of the main electrical path through the module and $R_{portion}$ is the resistance of the portion of the main electrical path with which the given shunt electrical path is in parallel.

Optionally, at least one shunt electrical path may be connected across one of the n-type and/or p-type thermoelectric elements, thereby protecting against failure of the thermoelectric element and/or its electrical connection to the main path.

In some embodiments, at least one shunt electrical path may be connected in parallel across one of the plurality of thermocouples. This may be more cost effective and easy to manufacture than providing a shunt electrical path across individual thermoelectric elements.

Optionally, a shunt electrical path may be connected in parallel across each of the plurality of thermocouples. This may be advantageous as if any one of the thermocouples in the thermoelectric module fail, then the corresponding shunt electrical path may operate to maintain performance of the module.

Optionally, at least one shunt electrical path may be connected in parallel to a portion of the main electrical path, the portion of the main electrical path comprising at least two thermocouples. Thus, a single shunt electrical path may be connected in parallel across multiple thermocouples. This may be particularly advantageous in parts of the main electrical path that are prone to failure. For example, these shunt electrical paths may be used to provide secondary shunt electrical paths in the event of a failure of a primary shunt electrical path connected across a single thermocouple.

The thermoelectric module may comprise at least one substrate. The plurality of thermocouples and the at least one shunt electrical path may be disposed on the at least one substrate. The use of at least one substrate may be advantageous as the substrate(s) may provide mechanical support to the thermoelectric module and/or may electrically insulate the thermocouples from any external surfaces.

Optionally, the at least one substrate may comprise, or consist essentially of, a ceramic or a polymeric material. The substrate(s) may comprise a thin film substrate.

The at least one substrate may comprise, or consist essentially of, a polymeric material, e.g. a polyimide such as Kapton®. The substrate(s) may be flexible or rigid.

The at least one shunt electrical path may be disposed on or in the substrate(s) using any suitable means. In some embodiments, the at least one shunt electrical path may be at least partially printed onto the at least one substrate, or disposed thereon or therein via other physical or chemical deposition techniques. Alternatively, the at least one shunt electrical path may be soldered onto the at least one substrate.

Optionally, the thermoelectric module may comprise a bottom substrate and a top substrate. The n-type and p-type thermoelectric elements may be disposed between the bottom and top substrates. In some embodiments, the at least one shunt electrical path may be disposed on the bottom substrate and/or the top substrate.

The plurality of thermocouples, and the n-type and p-type thermoelectric elements of each thermocouple, may be electrically connected in series by a plurality of electrical interconnects. Optionally, the plurality of electrical interconnects may comprise a plurality of wires and/or electrical connections printed on, or otherwise disposed on or in, the at least one substrate.

In some embodiments, the electrical interconnects may be disposed on or in the bottom and/or top substrates.

Optionally, the at least one shunt electrical path may have a lower resistivity than the plurality of electrical interconnects. Additionally or alternatively, the at least one shunt electrical path may have a smaller cross-sectional area than the plurality of electrical interconnects.

In some embodiments, the n-type and p-type thermoelectric elements may be directly electrically connected in series (i.e. without the need for any electrical interconnects).

In a second aspect of the present invention there is provided a thermoelectric generator comprising at least one thermoelectric module according to any embodiment of the first aspect of the invention.

In a third aspect of the present invention, there is provided a thermoelectric cooler or a thermoelectric heater comprising at least one thermoelectric module according to any embodiment of the first aspect of the invention.

In a fourth aspect of the present invention there is provided a method of manufacturing a thermoelectric module, e.g. a thermoelectric module according to any embodiment of the first aspect of the invention, the method including the steps of:

electrically connecting a plurality of n-type and p-type thermoelectric elements to form a plurality of thermocouples electrically connected in series, thereby providing a main electrical path through the thermoelectric module; and connecting at least one shunt electrical path in parallel to a portion of the main electrical path, the portion of the main electrical path comprising at least one of the thermocouples; wherein the resistance of a given shunt electrical path is less than the resistance of the main electrical path and more than the resistance of the portion of the main electrical path with which the given shunt electrical path is in parallel.

Embodiments of the invention will now be described, by way of example only, with reference to the accompanying drawings, in which:

Figure 1 is a side view of a standard thermoelectric module according to the prior art;

Figure 2 is an electrical schematic of the thermoelectric module of Figure 1;

Figure 3 is an electrical schematic of a thermoelectric module according to an embodiment of the invention;

Figure 4 is an electrical schematic of a thermoelectric module according to an embodiment of the invention;

Figure 5 is a side view of a thermoelectric module according to an embodiment of the invention;

Figure 6a is a plan view of a standard thermoelectric module according to the prior art without the top substrate and the electrical interconnects on the top substrate;

Figure 6b is a plan view of the top substrate missing from Figure 6a, looking through to the electrical interconnects disposed on the top substrate according to the prior art;

Figure 7 is a plan view of the bottom substrate, electrical interconnects and shunt electrical paths of a thermoelectric module in accordance with one embodiment of the invention;

Figure 8 is a plan view of the bottom substrate, electrical interconnects and the shunt electrical paths of a thermoelectric module in accordance with one embodiment of the invention;

Figure 9 is a plan view of a shunt electrical path of a thermoelectric module according to an embodiment of the invention connecting two electrical interconnects;

Figure 10 is a plan view of a shunt electrical path of a thermoelectric module according to an embodiment of the invention connecting two electrical interconnects.

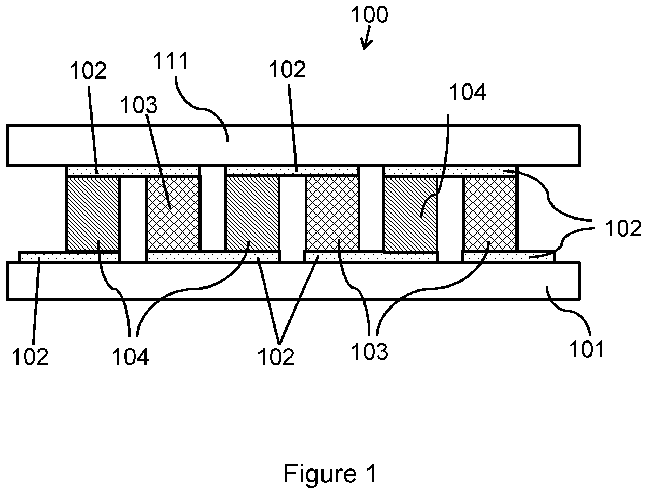

A side view of a standard thermoelectric module 100 as is well known in the prior art is shown in Figure 1. The thermoelectric module 100 comprises a bottom substrate 101, electrical interconnects 102 disposed on the bottom substrate 101, n-type thermoelectric elements 104, p-type thermoelectric elements 103, and electrical interconnects 102 disposed on the top substrate 111. The electrical interconnects 102 connect the n-type 104 and p-type 103 thermoelectric elements in series, thereby forming a string of electrically connected thermocouples.

The thermoelectric module 100 may be electrically connected to an external power source to provide electrical cooling or heating, or be thermally connected across a temperature difference to generate electrical power.

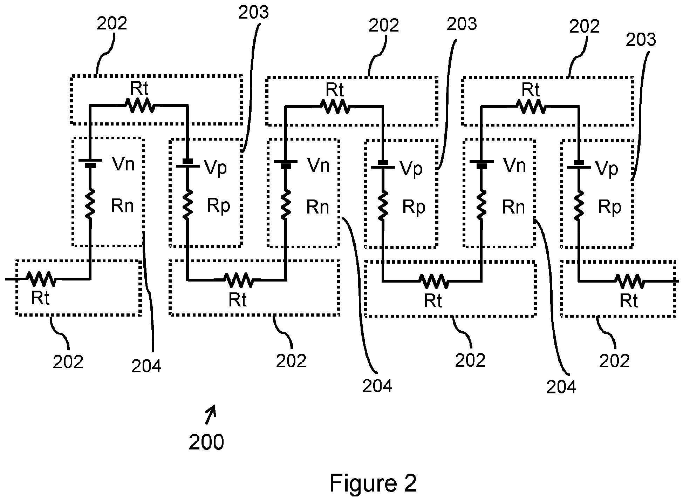

An electrical schematic of the thermoelectric modules in Figure 1 is shown in Figure 2. The thermoelectric elements 103 and 104 and their interfaces to the electrical interconnects 102 can be represented by an equivalent circuit 203 and 204 respectively, comprising the combination of a voltage source (Vp or Vn) and a resistance (Rp or Rn). The voltage source (Vp or Vn) is dependent on the temperature difference across the thermoelectric elements. The electrical interconnects 102 are represented by an equivalent circuit 202, comprising a resistance Rt. If any of the thermoelectric elements 203, 204 or their interfaces to the electrical interconnects fail (thereby creating an open circuit or a very large resistance) this results in the failure of the entire module 100.

If an additional electrical shunt path is provided, as in the present invention, the failure of one component still maintains the majority of the performance of the rest of the module by providing an alternative continuous electrical path for the current to follow.

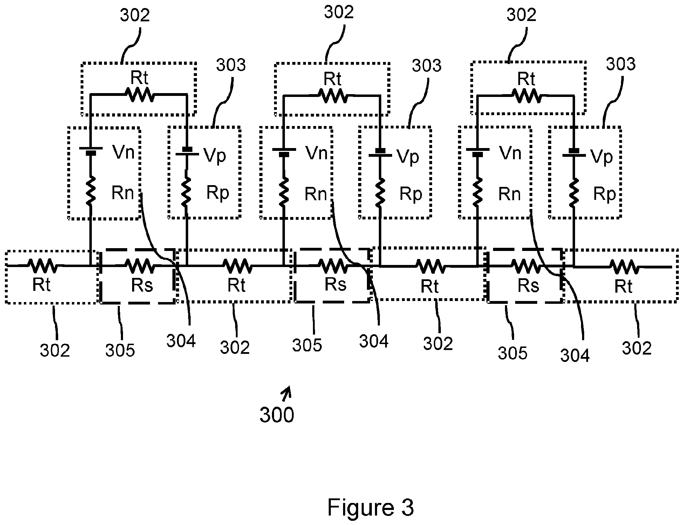

An electrical schematic of a thermoelectric module 300 according to an embodiment of the present invention is shown in Figure 3.

In Figure 3, the main electrical path through the thermoelectric module 300 is shown by the serpentine path through each of the thermoelectric elements 303, 304 connected in series (equivalent to the path in Figure 2). The shunt electrical paths 305 are each represented by a resistor Rs. In this example each shunt electrical path provides an alternative electrical path to the portion of the main electrical path comprising the n and p-type thermoelectric elements 304, 303 and the electrical interconnect 302 on the other substrate. Each n-type and p-type thermoelectric element 304, 303 connected by an electrical interconnect 302 can be defined as a thermocouple. Thus, each shunt electrical path 305 in Figure 3 is connected in parallel to one of a plurality of thermocouples.

In practice, failure may be most often seen in the thermoelectric elements 303, 304 or in the interfaces to the electrical interconnects in a thermoelectric module. If one of these components fails in Figure 3, there is still an alternative electrical path for current to follow through the shunt electrical path 305, thereby preventing failure of the whole device. In addition the shunt electrical path 305 provides an alternative electrical path to the main electrical path in the case of failure of the electrical interconnect 302 on the other substrate (i.e. the top substrate in this example).

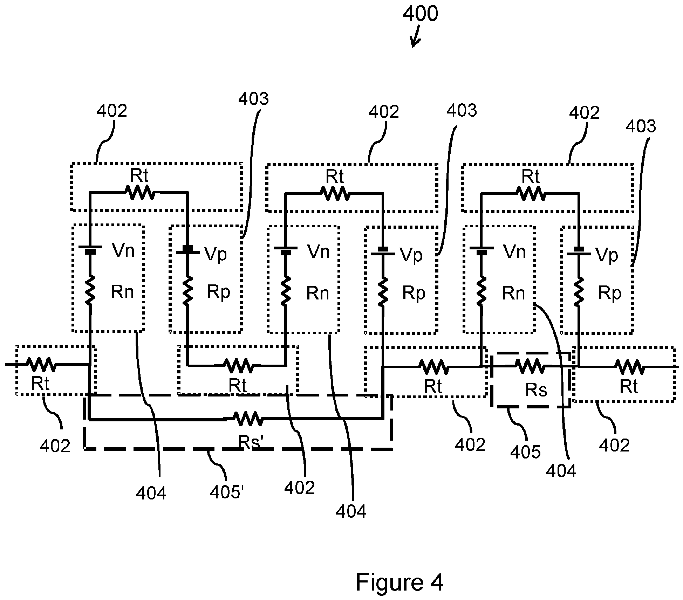

Figure 4 is an electrical schematic of a thermoelectric module 400 according to a further embodiment of the invention. In this example the n-type 404 and p-type 403 thermoelectric elements are still connected in series via a plurality of electrical interconnects 402. A shunt electrical path 405 with resistance Rs is connected in parallel to a thermocouple, as in Figure 3.

An additional shunt electrical path 405' with resistance Rs' is connected in parallel to two thermocouples, as opposed to a single thermocouple as in Figure 3. Therefore, if either of these two thermocouples fails the current will flow through the shunt electrical path 405' instead of the portion of the main electrical path through the thermocouples in question. This may be particularly advantageous if there are a large number of thermocouples in the module, as it will reduce manufacturing costs and the loss of multiple thermocouples in the event of a single failure will have less of an impact on the overall performance of the module.

Optionally, shunt electrical path 405' may be connected in parallel to more than two thermocouples. In other embodiments, shunt electrical path 405' may be connected in parallel to one or more shunt electrical paths 405, thereby forming a secondary shunt electrical path in the event of a failure of a primary shunt electrical path.

The introduction of the shunt electrical paths 305, 405, 405' results in a drop in performance of the thermoelectric module. For example, if the thermoelectric module in Figure 3 is used as a generator, assuming that the external load is matched to the thermoelectric module, each thermocouple will generate a voltage drop of $(Vn+Vp)/2$ across the external load and $(Vn+Vp)/2$ across the internal resistance consisting of the electrical interconnects and the thermoelectric elements. In a typical module, the resistance of the electrical interconnects is low compared to the (n-type and p-type) thermoelectric elements, i.e.:

$$Rt < Rn$$

$$Rt < Rp$$

Therefore, assuming Rt = 0 and using Ohm's law (V=IR) the electrical current flowing through the thermocouple, without a fault, is approximately given by:

$$Ic \approx (Vn+Vp)/2(Rn+Rp)$$

While the electrical current through the shunt electrical path is approximately given by

$$Is \approx (Vn+Vp)/2Rs$$

The power outputted to the load is proportional to the voltage across it (assumed constant) and the current through it, so the output power of the thermoelectric module, P, is proportionally given by:

$$P \propto Ic\text{-}Is$$

$$P \propto (Rs - (Rn+Rp)) / Rs/(Rn+Rp)$$

Therefore, in the example where the shunt electrical path is in parallel to a single thermocouple, in order to maximise the output power of the module before a fault occurs, the term (Rs - (Rn + Rp)) must be maximised. This leads to the requirement that Rs > Rn+Rp, i.e. the shunt electrical path has a resistance greater than the resistance of the n-type and p-type thermoelectric elements, which form a thermocouple, in order for the introduction of the shunt electrical path to not significantly affect the performance of the module before failure occurs.

In some embodiments, the shunt electrical path resistance Rs may preferably be greater than twice the resistance of the thermocouple (Rn+Rp). In some embodiments, the shunt electrical path resistance may preferably be greater than 10 times the thermocouple resistance (Rn+Rp).

If a thermoelectric element or electrical interconnect fails for which a shunt electrical path is connected in parallel (i.e. any of the thermoelectric elements 303, 304 in Figure 3), then ideally the shunt electrical path should also not then significantly limit the performance of the whole module. To fulfil this condition the electrical resistance of the shunt electrical path (Rs) should be less than the electrical resistance along the main electrical path through the module ($R_{main}$).

For example, if there are A thermocouples in the module, and the impact of the electrical interconnects (i.e. Rt) is again neglected the fraction of power output after failure of one thermocouple compared to the power output before failure is approximately given by:

A (Rn+Rp) / (A (Rn+Rp) + Rs - (Rn+Rp)) due to the resistance increase.

In order to limit this power loss the resistance of the shunt electrical path must satisfy the condition:

$$Rs < A (Rn+Rp).$$

Combined with the condition above, this leads to the equation:

$$Rn+Rp < Rs < A(Rn+Rp) \qquad -(1)$$

Both these conditions can be satisfied in a module with multiple thermocouples (i.e. A>1).

As shown in Figure 4, the shunt electrical paths do not have to provide an alternative electrical path for a single thermocouple, but instead may electrically shunt multiple thermocouples, i.e. B thermocouples where B is an integer greater than or equal to 2. In this case equation 1 is modified to:

$$B(Rn+Rp) < Rs < A(Rn+Rp) \qquad -(2)$$

To ensure high performance in a thermoelectric module used for heating or cooling a similar condition will apply. The conditions on the shunt electrical path can be generalised to include the shunt electrical path providing an alternative electrical path bypassing any numbers of thermocouples or thermoelectric elements, and including the case where the electrical interconnect resistance cannot be neglected (i.e. Rt is not small enough to be approximated to 0).

In general, the desired resistance of the shunt electrical path, Rs, can be related to the resistance of the main electrical path through the module, $R_{main}$, and the resistance of the portion of the main electrical path with which the shunt electrical path is connected in parallel, $R_{portion}$. The desired resistance must fulfil the conditions:

$$R_{portion} < Rs < R_{main} \qquad - (3)$$

To ensure optimal performance of the whole thermoelectric module both before failure and after a single failure, both of these conditions should be fulfilled as strongly as possible. Hence, it may be most advantageous when $R_{main}/R_{portion}$ is large, for example when each shunt electrical path is connected in parallel to a single thermocouple in a module comprising a large number of thermocouples.

In preferred embodiments, to simultaneously achieve best performance of the module before and after failure, the range of Rs may be smaller, given by:

$$0.5\ (R_{portion}+(R_{portion}+R_{main})^{0.5})< Rs\ <\ 5\ (R_{portion}+(R_{portion}+R_{main})^{0.5})\ -\ (4)$$

The inventors of the present invention have determined that equation 4 helps to minimise the loss of module performance both before and after failure of a component. In some embodiments it may be advantageous to have a larger loss of performance (e.g. output power) after a failure than before failure, as a failure is not guaranteed to occur.

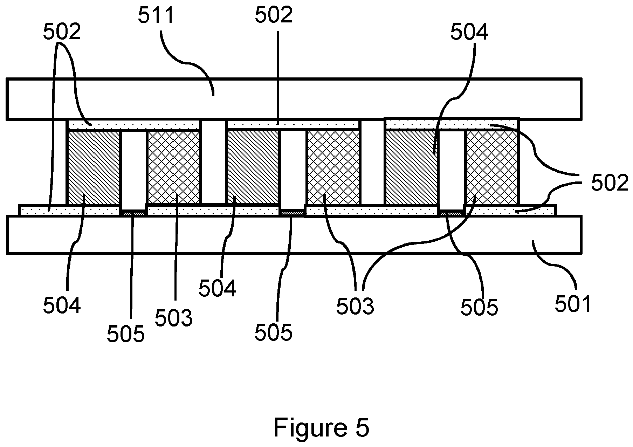

Figure 5 is a side view of a thermoelectric module according to an embodiment of the invention. As in Figure 1, the module comprises a bottom substrate 501 and a top substrate 511. A plurality of n-type 504 and p-type 503 thermoelectric elements are disposed between the substrates 501, 511 in an alternating arrangement.

The n-type 504 and p-type 503 thermoelectric elements are electrically connected in series to form a main electrical path through the module by a plurality of electrical interconnects 502 disposed on the bottom 501 and top 511 substrates. In this example, a thermocouple is defined as an n-type 504 and p-type 503 thermoelectric element connected by an electrical interconnect 502 disposed on the top substrate.

The electrical interconnects 502 may be formed of any electrically conductive material. Optionally, the electrical interconnects 502 may be printed on the bottom 501 and top 511 substrates.

In Figure 5, a plurality of shunt electrical paths 505 are disposed on the bottom substrate 501. The shunt electrical paths 505 are electrically connected to the adjacent electrical interconnects 502 disposed on or in the bottom substrate 501. Thus, as in Figure 3, each shunt electrical path 505 is connected in parallel across a thermocouple.

The shunt electrical paths 505 may be disposed on or in the bottom substrate 501 at the same time as the electrical interconnects 502. Optionally, the shunt electrical paths 505 may be formed of the same material as, or a similar material to, the electrical interconnects 502. The shunt electrical path 505 may not be the same thickness as the electrical interconnects 502.

The shunt electrical path 505 may be formed by patterning a direct bonded metal on the bottom substrate 501, including but not limited to copper, silver or aluminium. Optionally, the shunt electrical path 505 may have a protective surface layer to avoid diffusion, degradation or oxidation, for example a nickel layer. The shunt electrical path may be disposed on the bottom substrate by a printing process, or other form of physical or chemical deposition.

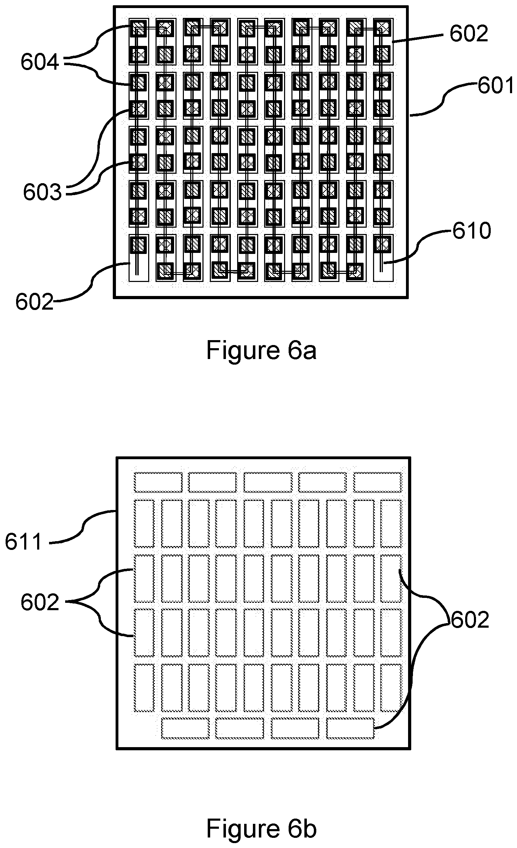

Figure 6a is a plan view of a standard thermoelectric module according to the prior art (e.g. the module in Figure 1) without the top substrate. Figure 6a shows the plurality of n-type 604 and p-type 603 thermoelectric elements and electrical interconnects 602 disposed on the bottom substrate 601. The main electrical path through the modules is indicated by path 610.

Figure 6b is a plan view of the corresponding top substrate 611, wherein the substrate is depicted as transparent to show the arrangement of the electrical interconnects 602 disposed on the top substrate 611 which is necessary to complete the series of electrical connections between the n-type 604 and p-type 603 thermoelectric elements in Figure 6a, i.e. to complete the main electrical path 610. In practice, the top substrate 611 is not necessarily transparent.

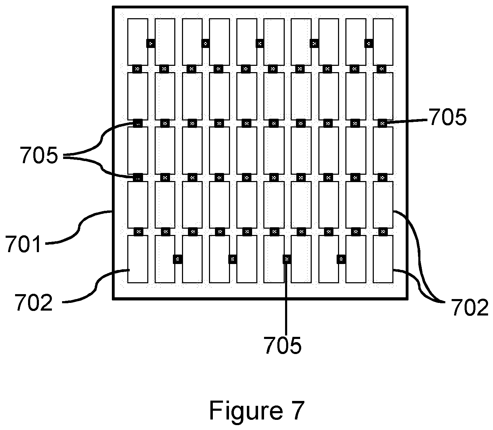

Figure 7 shows a plan view of a bottom substrate 701 of a thermoelectric module according to an embodiment of the invention (e.g. the module in Figure 3). The plurality of electrical interconnects 702 disposed on the bottom substrate 701 are electrically connected to shunt electrical paths 705 disposed on the bottom substrate 701. The shunt electrical paths 705 may be the same width and/or thickness as the electrical interconnects 702, or they may be a different width and/or thickness from the electrical interconnects 702.

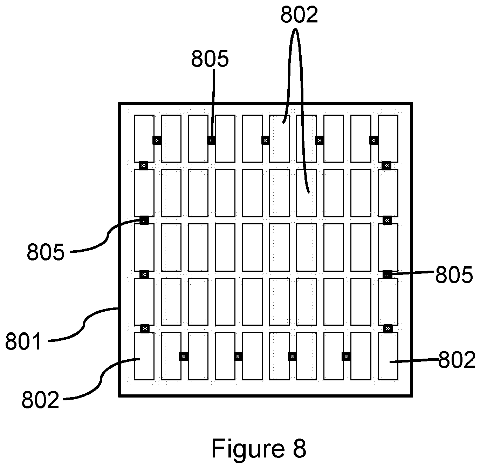

In some embodiments, the shunt electrical path(s) may only provide an alternative (e.g. bypass) electrical path in areas of the module most prone to failure. For example, as shown in the example bottom substrate 801 of Figure 8, shunt electrical paths 805 connected between electrical interconnects 802 may only be used to shunt thermocouples located near the edge of the module (e.g. near the perimeter of the bottom substrate 801).

In some embodiments, shunt electrical paths may be present in or on one or both substrates (e.g. the bottom and/or the top substrate). In other embodiments, the shunt electrical paths may not be disposed in or on a substrate. Optionally, shunt electrical paths may be present in or on the substrate that is least likely to have a failure of the electrical interconnects disposed thereon, for example the substrate that is nearer, in use, the ambient temperature.

If, as in the example in Figure 3, the shunt electrical path is connected in parallel to one thermocouple and its electrical interconnect, then the first condition in equation 3, $Rs > R_{portion}$, becomes $Rs > (Rn + Rp + Rt)$. For a high-performance, fault-tolerant thermoelectric module, the resistance of the electrical interconnects (Rt) should be much lower than the resistance of thermoelectric material (Rn, Rp), i.e. $Rt < Rn+Rp$. Therefore, the shunt electrical path resistance Rs should be much larger than electrical interconnect resistance Rt to ensure that the outputs of the module are not significantly affected by the shunt electrical path.

In one embodiment of the invention, the shunt electrical path is made of an electrically conductive material with an electrical resistivity lower than the electrical resistivity of the electrical interconnects.

However, it may be advantageous to manufacture the shunt electrical path using an electrically conducting material with a resistivity similar to the electrical resistivity of the electrical interconnects. For example, this may simplify processing or allow fewer manufacturing steps. Therefore, the required difference in resistance between the shunt electrical path and the electrical interconnects can be produced due to a difference in the geometry of the components.

The shunt electrical path(s) may have a significantly smaller cross-sectional area perpendicular to the current flow compared to the electrical interconnects. For example, Figure 5 illustrates that shunt electrical paths 505 with a lower thickness than the electrical interconnects 502 can be used. Figure 7 also shows that the shunt electrical paths 705 may be narrower than the electrical interconnects 702.

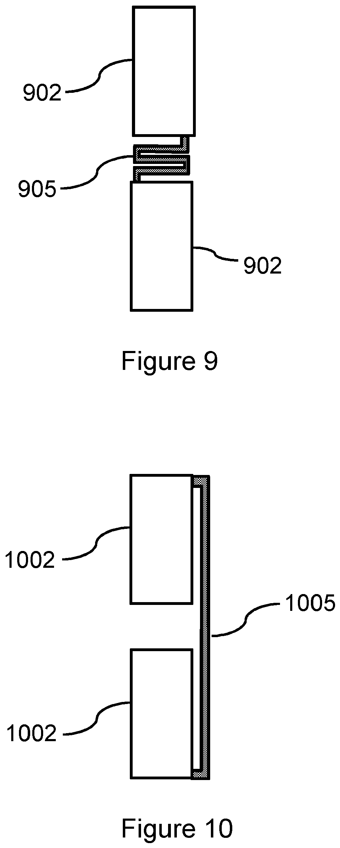

Additionally or alternatively, the shunt electrical path may increase its resistance compared with the electrical interconnects resistance by increasing the length of the shunt electrical path through which the current flows (in the event of a failure). For example, the shunt electrical path 905 may comprise a serpentine pattern between the electrical interconnects 902, as shown in Figure 9. The shunt electrical paths may be configured to follow any tortuous path comprising one or more bends, e.g. a helix or the serpentine pattern described previously.

Additionally or alternatively, the shunt electrical path(s) 1005 may not be connected across the shortest distance between the electrical interconnects 1002, as shown in Figure 10, thereby also increasing the length of the shunt electrical path 1005.

In some embodiments, the electrical resistivity of the shunt electrical path(s) may be different from (e.g. higher than) the electrical resistivity of the electrical interconnects and the cross sectional area of the shunt electrical path(s) may be lower than the cross sectional area of the electrical interconnects.

**Claims**

1. A thermoelectric module (300) comprising:

   a plurality of thermocouples electrically connected in series to provide a main electrical path through the thermoelectric module, each thermocouple comprising an n-type thermoelectric element (304) and a p-type thermoelectric element (303); and
   at least one shunt electrical path (305) connected in parallel to a portion of the main electrical path, the portion of the main electrical path comprising at least one of the thermocouples;
   wherein the resistance of a given shunt electrical path is:

   less than the resistance of the main electrical path; and
   more than the resistance of the portion of the main electrical path with which the given shunt electrical path is in parallel.

2. The thermoelectric module of claim 1, wherein the resistance of a given shunt electrical path, $R_s$, satisfies the equation:

$$\frac{1}{2}\left(R_{portion}+(R_{portion}+R_{main})^{0.5}\right)< R_s < 5\left(R_{portion}+(R_{portion}+R_{main})^{0.5}\right)$$

wherein $R_{main}$ is the resistance of the main electrical path and $R_{portion}$ is the resistance of the portion of the main electrical path with which the given shunt electrical path is in parallel.

3. The thermoelectric module of claim 1 or claim 2, further comprising at least one shunt electrical path connected in parallel across one of the plurality of thermocouples.

4. The thermoelectric module of claim 1, claim 2 or claim 3, further comprising a shunt electrical path connected in parallel across each of the plurality of thermocouples.

5. The thermoelectric module of any one of claims 1 to 4, further comprising at least one shunt electrical path connected in parallel to a portion of the main electrical path, the portion of the main electrical path comprising at least two thermocouples.

6. The thermoelectric module of any one of claims 1 to 5, further comprising at least one substrate, wherein the plurality of thermocouples and the at least one shunt electrical path are disposed on or in the at least one substrate.

7. The thermoelectric module of claim 6, wherein the at least one substrate comprises, or consists essentially of a ceramic or a polymeric material.

8. The thermoelectric module of claim 6 or claim 7, wherein the at least one shunt electrical path is at least partially printed onto the at least one substrate.

9. The thermoelectric module of any one of claims 6 to 8, wherein the at least one substrate comprises a first substrate and a second substrate, wherein:

the plurality of thermocouples are disposed between the first and second substrates; and
the at least one shunt electrical path is disposed on or in the first substrate.

10. The thermoelectric module of any one of claims 1 to 9, wherein the plurality of thermocouples, and the n-type and p-type thermoelectric elements of each thermocouple, are electrically connected in series by a plurality of electrical interconnects (302).

11. The thermoelectric module of claim 10, wherein the at least one shunt electrical path has a higher resistivity than the plurality of electrical interconnects.

12. The thermoelectric module of claim 10 or claim 11, wherein the at least one shunt electrical path has a smaller cross-sectional area than the plurality of electrical interconnects.

13. A thermoelectric generator comprising at least one thermoelectric module according to any one of claims 1 to 12.

14. A thermoelectric cooler or a thermoelectric heater comprising at least one thermoelectric module according to any one of claims 1 to 12.

15. A method of manufacture of a thermoelectric module, (300) the method including the steps of:

electrically connecting a plurality of n-type (304) and p-type (303) thermoelectric elements to form a plurality of thermocouples electrically connected in series, thereby providing a main electrical path through the thermoelectric module; and
connecting at least one shunt electrical path (305) in parallel to a portion of the main electrical path, the portion of the main electrical path comprising at least one of the thermocouples, wherein the resistance of a given shunt electrical path is less than the resistance of the main electrical path and more than the resistance of the portion of the main electrical path with which the given shunt electrical path is in parallel.

**Patentansprüche**

1. Thermoelektrisches Modul (300) umfassend:

eine Vielzahl von Thermoelementen, die elektrisch in Reihe geschaltet sind, um einen elektrischen Hauptweg durch das thermoelektrische Modul bereitzustellen, wobei jedes Thermoelement ein thermoelektrisches Element (304) vom n-Typ und ein thermoelektrisches Element (303) vom p-Typ umfasst; und
zumindest einen elektrischen Nebenschlussweg (305), der parallel zu einem Abschnitt des elektrischen Hauptweges geschaltet ist, wobei der Abschnitt des elektrischen Hauptweges zumindest eines der Thermoelemente umfasst;
wobei der Widerstand eines gegebenen elektrischen Nebenschlussweges:

kleiner als der Widerstand des elektrischen Hauptweges ist; und
größer als der Widerstand des Abschnitts des elektrischen Hauptweges ist, zu dem der gegebene elektrische Nebenschlussweg parallel ist.

2. Thermoelektrisches Modul nach Anspruch 1, wobei der Widerstand eines gegebenen elektrischen Nebenschlussweges, $R_S$, die Gleichung erfüllt:

$$\tfrac{1}{2}\left(R_{Abschnitt} + (R_{Abschnitt} + R_{Haupt})^{0,5}\right) < R_S < 5\left(R_{Abschnitt} + (R_{Abschnitt} + R_{Haupt})^{0,5}\right)$$

wobei $R_{Haupt}$ der Widerstand des elektrischen Hauptweges ist und $R_{Abschnitt}$ der Widerstand des Abschnitts des elektrischen Hauptweges ist, zu dem der gegebene elektrische Nebenschlussweg parallel ist.

3.  Thermoelektrisches Modul nach Anspruch 1 oder Anspruch 2, weiter umfassend zumindest einen elektrischen Nebenschlussweg, der über eines der Vielzahl von Thermoelementen parallel geschaltet ist.

4.  Thermoelektrisches Modul nach Anspruch 1, Anspruch 2 oder Anspruch 3, weiter umfassend einen elektrischen Nebenschlussweg, der über jedes der Vielzahl von Thermoelementen parallel geschaltet ist.

5.  Thermoelektrisches Modul nach einem der Ansprüche 1 bis 4, weiter umfassend zumindest einen elektrischen Nebenschlussweg, der parallel zu einem Abschnitt des elektrischen Hauptweges geschaltet ist, wobei der Abschnitt des elektrischen Hauptweges zumindest zwei Thermoelemente umfasst.

6.  Thermoelektrisches Modul nach einem der Ansprüche 1 bis 5, weiter umfassend zumindest ein Substrat, wobei die Vielzahl von Thermoelementen und der zumindest eine elektrische Nebenschlussweg auf oder in dem zumindest einen Substrat angeordnet sind.

7.  Thermoelektrisches Modul nach Anspruch 6, wobei das zumindest eine Substrat eine Keramik oder ein polymeres Material umfasst oder im Wesentlichen daraus besteht.

8.  Thermoelektrisches Modul nach Anspruch 6 oder Anspruch 7, wobei der zumindest eine elektrische Nebenschlussweg zumindest teilweise auf das zumindest eine Substrat gedruckt ist.

9.  Thermoelektrisches Modul nach einem der Ansprüche 6 bis 8, wobei das zumindest eine Substrat ein erstes Substrat und ein zweites Substrat umfasst, wobei:

    die Vielzahl von Thermoelementen zwischen den ersten und zweiten Substraten angeordnet sind; und
    der zumindest eine elektrische Nebenschlussweg auf oder in dem ersten Substrat angeordnet ist.

10. Thermoelektrisches Modul nach einem der Ansprüche 1 bis 9, wobei die Vielzahl von Thermoelementen und die thermoelektrischen Elemente vom n-Typ und p-Typ jedes Thermoelementes durch eine Vielzahl von elektrischen Verbindungen (302) in Reihe geschaltet sind.

11. Thermoelektrisches Modul nach Anspruch 10, wobei der zumindest eine elektrische Nebenschlussweg einen höheren spezifischen Widerstand als die Vielzahl von elektrischen Verbindungen aufweist.

12. Thermoelektrisches Modul nach Anspruch 10 oder Anspruch 11, wobei der zumindest eine elektrische Nebenschlussweg eine kleinere Querschnittsfläche als die Vielzahl von elektrischen Verbindungen aufweist.

13. Thermoelektrischer Generator, der zumindest ein thermoelektrisches Modul nach einem der Ansprüche 1 bis 12 umfasst.

14. Thermoelektrische Kühlvorrichtung oder thermoelektrische Heizvorrichtung, die zumindest ein thermoelektrisches Modul nach einem der Ansprüche 1 bis 12 umfasst.

15. Verfahren zur Herstellung eines thermoelektrischen Moduls (300), wobei das Verfahren die Schritte aufweist von:

    elektrisch Verbinden einer Vielzahl von thermoelektrischen Elementen vom n-Typ (304) und p-Typ (303), um eine Vielzahl von elektrisch in Reihe geschalteten Thermoelementen zu bilden, wodurch ein elektrischer Hauptweg durch das thermoelektrische Modul bereitgestellt wird; und
    Verbinden zumindest eines elektrischen Nebenschlussweges (305) parallel zu einem Abschnitt des elektrischen Hauptweges, wobei der Abschnitt des elektrischen Hauptweges zumindest eines der Thermoelemente umfasst, wobei der Widerstand eines gegebenen elektrischen Nebenschlussweges kleiner als der Widerstand des elektrischen Hauptweges und größer als der Widerstand des Abschnitts des elektrischen Hauptweges ist, zu dem der gegebene elektrische Nebenschlussweg parallel geschaltet ist.

**Revendications**

1. Module thermoélectrique (300) comprenant
   une pluralité de thermocouples connectés électriquement en série pour fournir un trajet électrique principal à travers le module thermoélectrique, chaque thermocouple comprenant un élément thermoélectrique de type n (304) et un élément thermoélectrique de type p (303) ; et
   au moins un trajet électrique de dérivation (305) connecté en parallèle à une partie du trajet électrique principal, la partie du trajet électrique principal comprenant au moins l'un des thermocouples ;
   dans lequel la résistance d'un trajet électrique de dérivation donné est :

   inférieure à la résistance du trajet électrique principal ; et
   supérieure à la résistance de la partie du trajet électrique principal avec laquelle le trajet électrique de dérivation donné est en parallèle.

2. Module thermoélectrique selon la revendication 1, dans lequel la résistance d'un trajet électrique de dérivation donné, $R_s$, répond à l'équation :

$$\frac{1}{2}\left(R_{portion}+(R_{portion}+R_{main})^{0.5}\right)< R_s < 5\left(R_{portion}+(R_{portion}+R_{main})^{0.5}\right)$$

   où $R_{main}$ est la résistance du trajet électrique principal et $R_{portion}$ est la résistance de la partie du trajet électrique principal avec laquelle le trajet électrique de dérivation donné est en parallèle.

3. Module thermoélectrique selon la revendication 1 ou la revendication 2, comprenant en outre au moins un trajet électrique de dérivation connecté en parallèle à travers l'un de la pluralité de thermocouples.

4. Module thermoélectrique selon la revendication 1, la revendication 2 ou la revendication 3, comprenant en outre un trajet électrique de dérivation connecté en parallèle à travers chacun de la pluralité de thermocouples.

5. Module thermoélectrique selon l'une quelconque des revendications 1 à 4, comprenant en outre au moins un trajet électrique de dérivation connecté en parallèle à une partie du trajet électrique principal, la partie du trajet électrique principal comprenant au moins deux thermocouples.

6. Module thermoélectrique selon l'une quelconque des revendications 1 à 5, comprenant en outre au moins un substrat, dans lequel la pluralité de thermocouples et le au moins un trajet électrique de dérivation sont disposés sur ou dans le au moins un substrat.

7. Module thermoélectrique selon la revendication 6, dans lequel le au moins un substrat comprend ou consiste essentiellement en une céramique ou un matériau polymère.

8. Module thermoélectrique selon la revendication 6 ou la revendication 7, dans lequel le au moins un trajet électrique de dérivation est au moins partiellement imprimé sur le au moins un substrat.

9. Module thermoélectrique selon l'une quelconque des revendications 6 à 8, dans lequel le au moins un substrat comprend un premier substrat et un second substrat, dans lequel :

   la pluralité de thermocouples sont disposés entre les premier et second substrats ; et
   le au moins un trajet de dérivation électrique est disposé sur ou dans le premier substrat.

10. Module thermoélectrique selon l'une quelconque des revendications 1 à 9, dans lequel la pluralité de thermocouples et les éléments thermoélectriques de type n et de type p de chaque thermocouple sont connectés électriquement en série par une pluralité d'interconnexions électriques (302).

11. Module thermoélectrique selon la revendication 10, dans lequel le au moins un trajet électrique de dérivation a une résistivité supérieure à la pluralité d'interconnexions électriques.

**12.** Module thermoélectrique selon la revendication 10 ou la revendication 11, dans lequel le au moins un trajet électrique de dérivation a une surface de section transversale inférieure à la pluralité d'interconnexions électriques.

**13.** Générateur thermoélectrique comprenant au moins un module thermoélectrique selon l'une quelconque des revendications 1 à 12.

**14.** Refroidisseur thermoélectrique ou réchauffeur thermoélectrique comprenant au moins un module thermoélectrique selon l'une quelconque des revendications 1 à 12.

**15.** Procédé de fabrication d'un module thermoélectrique (300), le procédé incluant les étapes consistant à :

connecter électriquement une pluralité d'éléments thermoélectriques de type n (304) et de type p (303) pour former une pluralité de thermocouples connectés électriquement en série, en fournissant ainsi un trajet électrique principal à travers le module thermoélectrique ; et

connecter au moins un trajet électrique de dérivation (305) en parallèle à une partie du trajet électrique principal, la partie du trajet électrique principal comprenant au moins l'un des thermocouples,

dans lequel la résistance d'un trajet électrique de dérivation donné est inférieure à la résistance du trajet électrique principal et supérieure à la résistance de la partie du trajet électrique principal avec laquelle le trajet électrique de dérivation donné est en parallèle.

Figure 1

Figure 2

Figure 3

Figure 5

Figure 6a

Figure 6b

705

705

701

702

702

705

Figure 7

Figure 8

Figure 9

Figure 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 9522188 A
- US 3632451 A
- WO 1073824 A